(19) **Europäisches Patentamt European Patent Office Office européen des brevets**

(11) **EP 1 271 770 B1**

(12) **EUROPEAN PATENT SPECIFICATION**

(45) Date of publication and mention
of the grant of the patent:
**06.08.2008 Bulletin 2008/32**

(51) Int Cl.:
*H03G 3/30* (2006.01)     *H03G 3/20* (2006.01)
*H03F 3/45* (2006.01)     *H04L 25/06* (2006.01)

(21) Application number: **02405501.4**

(22) Date of filing: **18.06.2002**

(54) **Analog base band unit for RF receiver and method for using the same**

Analoge Basisbandeinheit für Hochfrequenzempfänger und Verfahren zu ihrer Nutzung

Unité de bande de base pour poste de réception radiofréquences et méthode de son utilisation

(84) Designated Contracting States:
**AT BE CH CY DE DK ES FI FR GB GR IE IT LI LU MC NL PT SE TR**

(30) Priority: **19.06.2001 EP 01810598**

(43) Date of publication of application:
**02.01.2003 Bulletin 2003/01**

(73) Proprietor: **u-blox AG**
**8800 Thalwil (CH)**

(72) Inventor: **Spiegel, Solon**
**8008 Z-rich (CH)**

(74) Representative: **Wagner, Wolfgang Heribert**
**c/o Zimmerli, Wagner & Partner AG**
**Löwenstrasse 19**
**8001 Zürich (CH)**

(56) References cited:
**US-A- 5 471 665**     **US-A- 5 617 060**
**US-A- 5 901 347**     **US-A- 6 031 878**

## Description

### Field of the invention

The invention concerns an analog base band unit for a RF receiver according to the precharacterizing clause of claim 1. Units of this type are used in receivers serving various purposes, in particular receivers used in wireless or TV sets, cellular phones or GPS kits. The invention also concerns a method for using the inventive analog base band unit to process a GPS signal.

### Prior art

Many analog base band units of the generic type are known. One particular problem associated with known designs is that the automatic gain control methods used do not compensate for changes in the filter characteristics of the system that go along with variations of the gain. This may lead to shifts in cut-off frequencies resulting in insufficient suppression of DC and low frequency components resulting from local oscillator self-mixing or blocking self-mixing effects. Problems of this type are particularly severe if signals of widely differing properties are to be processed by the receiver. A receiver with an automatic gain control and offset compensation is known from US-A-6 031 878.

It is an object of the invention to provide an analog base band unit for a RF receiver of the generic type which will work dependably with signals requiring widely varying gain. Another object of the invention - which is related to the above-mentioned object - is to provide an analog base band unit for a multi-standard RF receiver capable of processing RF signals of quite different properties, in particular signals pertaining to the GPS system and to wireless communication systems.

### Summary of the invention

The analog base band unit according to the invention offers continuous adaptation of its filter characteristics to the properties of the signal and in particular to the gain of the variable gain amplifier unit. In particular, the cut-off frequency or frequencies can be kept essentially constant by compensating for the effects of varying gain.

With appropriate modifications the analog base band unit can be adapted to various signal types implicating widely differing requirements, in particular frequency hopping systems like bluetooth requiring very fast responses on the one hand and TDMA, CDMA and GPS where response time requirements are more moderate but where, e. g., the intermittent character of the processed signal poses problems of a different type or where low power consumption requirements are particularly stringent. At the same time, the analog base band unit according to the invention offers efficient suppression of low frequency components, in particular DC offset.

### Brief description of the drawings

In the following the invention is described in more detail with reference to drawings showing an embodiment of the invention where

Fig. 1    shows an overview, partly a block diagram of an analog base band unit according to the invention,

Fig. 2    a more detailed diagram of part of the reverse path unit of the embodiment according to Fig. 1,

Fig. 3    a more detailed diagram of a first part of the control unit of the embodiment according to Fig. 1,

Fig. 4    a more detailed diagram of a second part of the control unit of the embodiment according to Fig. 1,

Fig. 5    the carrier to noise ratio at the output of an analog base band unit according to the invention processing a GPS signal, as a function of its bandwidth, and

Fig. 6    correlation signals as functions of time shift of a GPS signal processed by an analog base band unit according to the invention, at different bandwidths.

### Description of the preferred embodiments

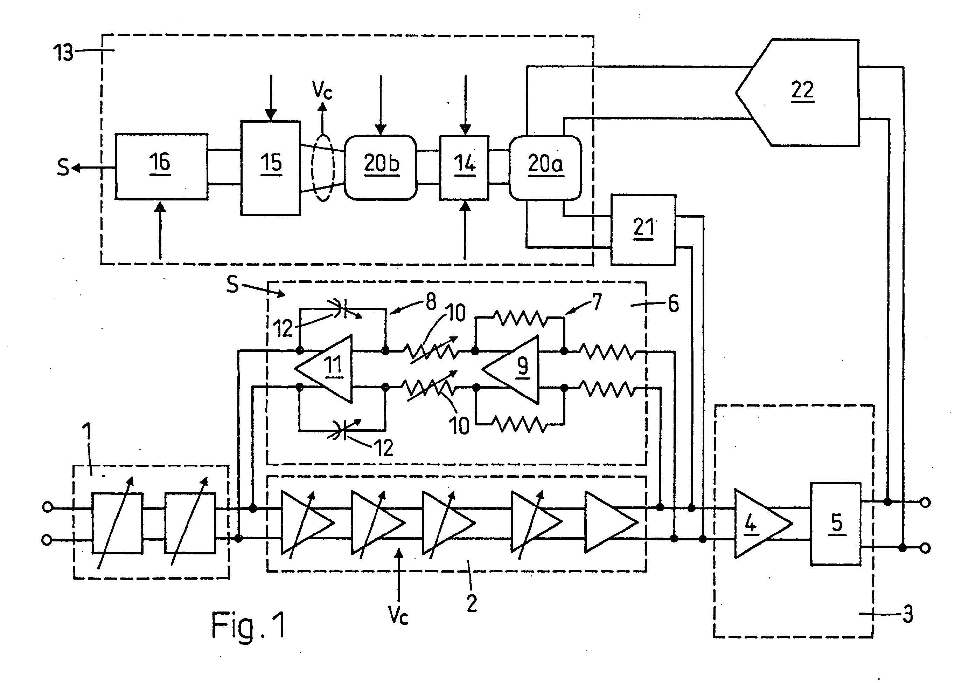

The analog base band unit of Fig. 1 is part of a RF receiver also comprising an analog front end and a digital base band unit as well as auxiliary components as is well known in the art. The input receiving the output signal of a mixer is directly connected to a cascaded low pass filter 1. Low pass filter 1 has variable properties, so it can be calibrated to provide compensation for component tolerances and adapted to the chosen mode of operation. Its output is connected to the input of a variable gain amplifier unit 2 in the shape of an amplifier chain made up of series connected amplifiers at least part of which are controllable with respect to gain. As controllable amplifiers Gilbert cells or amplification cells with operational amplifiers may be employed. This will ensure high gain and control range, low phase noise and coherent amplification as required. With Gilbert cells an analog control voltage $V_c$ can be directly applied to control their gain whereas amplification cells have to be controlled via switching networks containing resistors and the analog control voltage $V_c$ will have to be converted to a digital signal controlling the switches via a discrete control interface. The variable gain amplifier unit 2 is followed by an A/D converter 3 consisting of a sampler 4 and a quantizer 5.

A reverse path unit 6 connects the output of variable gain amplifier unit 2 to its input, thus completing a feedback circuit containing the latter. It comprises an inverter network 7, followed by a tunable filter network 8. The inverter network 7 comprises a local feedback loop with an operational amplifier 9 and resistors in the local feedback loop as well as in series with the operational amplifiers. The filter network 8 comprises controllable variable resistances 10 in series with another feedback loop comprising an operational amplifier 11 with feedback via controllable variable capacitances 12. Together with the reverse path unit 6, variable gain amplifier unit 2 provides a feedback circuit offering variable gain amplification and at the same time controllable and adaptable suppression of DC and low frequency components.

For the purpose of controlling variable amplifier unit 2 and reverse path unit 6 a control unit 13 is provided which comprises an integrator 14 in series with a quantizer 15 for converting the output signal of integrator 14 to a digital signal and a decoder 16 for processing the same further to produce control signals for adapting the variable resistances 10 and variable capacitances 12 of reverse path unit 6.

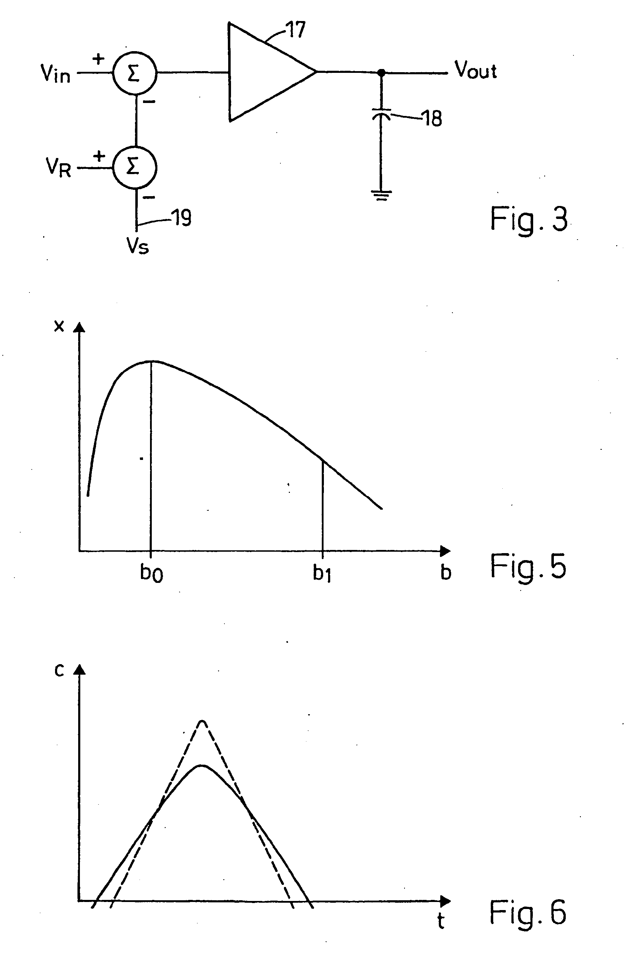

The integrator 14 comprises (Fig. 3) a transconductance 17, whose output is connected to ground via a condensor 18. Via a speed-up input 19 a signal can be applied which is added to the input voltage. If a speed-up signal in the shape of a pulsed negative speed-up voltage $V_s$ is applied the operation point of the loop is changed and excess charge removed from condenser 18. As a consequence, the settling time of the gain control loop is reduced. This feature provides short attack time and high dynamic range of the gain control for modes of operation where this is required.

Control unit 13 also comprises a first switchable selector 20a connecting one of two inputs to the input of integrator 14. A first input of selector 20a is connected to the output of a first monitoring unit, a synchronous AM detector 21 connected to the output of the variable gain amplifier unit 2. A second input of first selector 20a is connected to the output of a second monitoring unit, a control logic 22, e. g., a D/A converter to which the output signal of A/D converter 3 is fed. A second switchable selector 20b either connects the output of integrator 14 to the input of quantizer 15 or transmits a signal from the digital base band (not shown) to the same. The output voltage $V_c$ of second selector 20b is used as a gain control signal controlling the gain of variable gain amplifier unit 2.

Synchronous AM detector 21 comprises a full-wave rectifier and, optionally, a one-pole low pass filter. Control logic 22 can have high or low resolution according to requirements. Usually, low resolution will be sufficient.

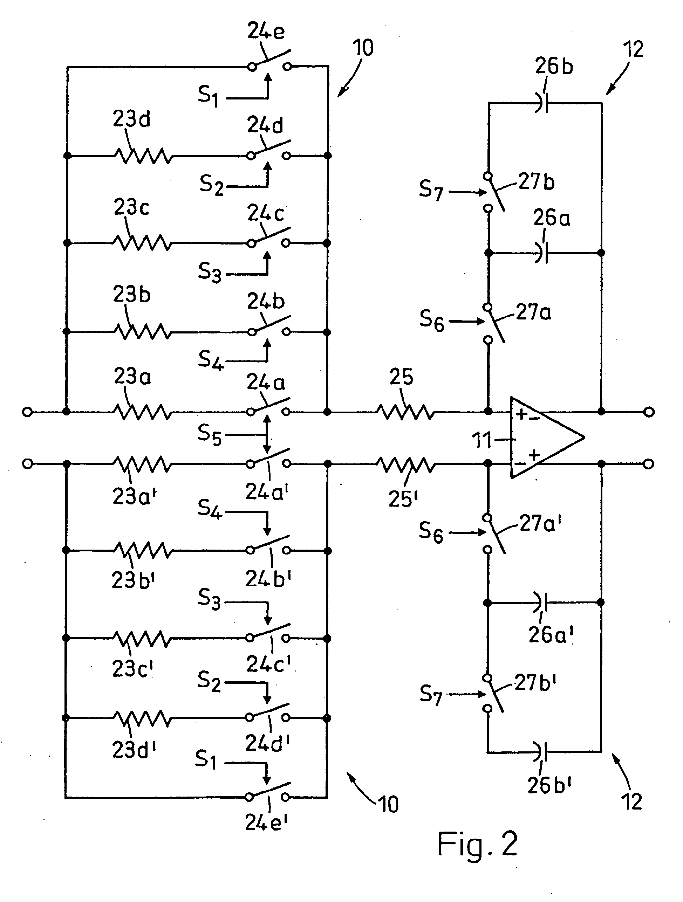

Of the parallel variable resistances 10 each comprises - only the upper one will be described with reference to the drawings, the lower one being equal - a circuit containing (Fig. 2) resistors 23a-d of decreasing magnitude in parallel, each of them in series with one of switches 24a-d, as well as an additional switch 24e in parallel with resistors 23a-d. Via resistor 25 the circuit just described is connected to operational amplifier 11. Of the variable capacitances 12 of filter network 8 each comprises - here again only the upper one of capacitances 12 will be described - capacitors 26a,b in parallel. A switch 27a controls a loop containing capacitors 26a,b whereas a further switch 27b can be used to switch single capacitor 26b, which may be external, on and off.

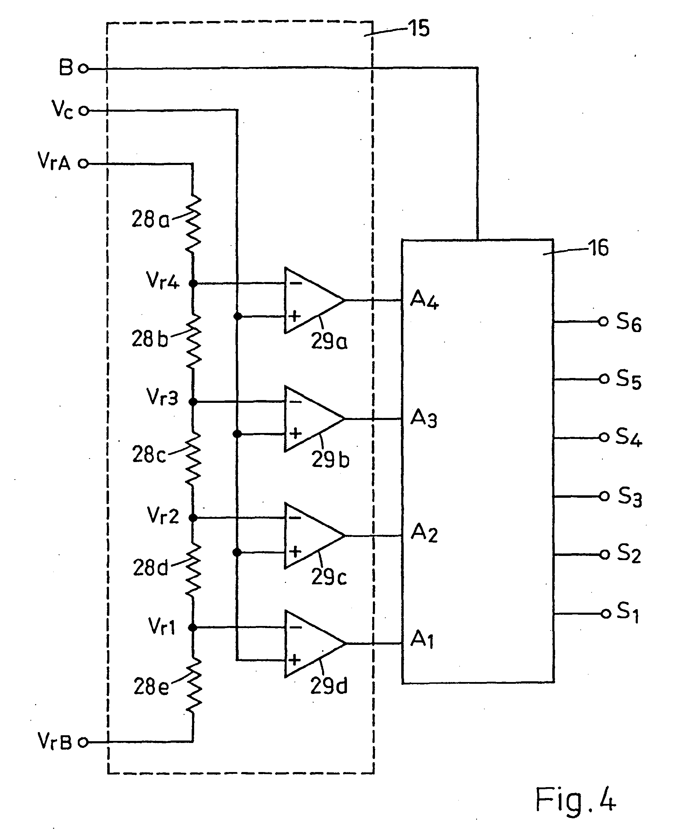

Quantizer 15 (Fig. 4) comprises a series of resistors 28a-e dividing the voltage span between a higher basic reference voltage $V_{rA}$ and a lower basic reference voltage $V_{rB}$ and thereby creating four reference voltages $V_{r1}$ - $V_{r4}$ which are fed to the inverting inputs of four comparators 29a-d whereas the input signal, voltage $V_c$ from the output of second selector 20b which also controls variable amplifier unit 2, is fed to their non-inverting inputs in parallel. The either high or low output signals $A_1$-$A_4$ of comparators 29a-d amount to a 4-bit digital signal which represents the input signal voltage and is fed to the decoder 16 where it is decoded and converted to provide five components of a seven digital levels output signal whose digits directly control switches 24a-e, 24a'-e' in the filter network 8 of reverse path unit 6 as indicated in Fig. 2.

The first five digits of the output signal S=(S1,...,S7) are derived from input signals $A_1$-$A_4$ according to the following rules:

$$S_1 = \bar{A}_1$$

$$S_2 = A_1\bar{A}_2$$

$$S_3 \ = \ A_2\bar{A}_3$$

$$S_4 \ = \ A_3\bar{A}_4$$

$$S_5 \ = \ A_4$$

Consequently, $S_1$ is high if and only if the input voltage $V_c$ of quantizer 15 is smaller than the lowest of the reference voltages $V_{r1}$, $S_2$ is high if and only if $V_c$ is larger than first reference voltage $V_{r1}$ and smaller than second reference voltage $V_{r2}$ and so on. $S_5$ is high if and only if input voltage $V_c$ is larger than the highest reference voltage, $V_{r4}$. So if the voltage $V_c$ - and, as a consequence, the gain of variable amplifier unit 2, is low - lower than $V_{r1}$ - $S_1$ is high. Switches 24e, 24e' in variable resistances 10 of reverse path unit 6 are closed whereas the remaining switches there are open. The time constant of reverse path unit 6 is consequently small. With $V_c$ increasing, resistors 24d, 24d', then larger resistors 24c, 24c' etc. are activated in turn which results in a rise of the time constant. Switches 27a, 27a' in variable capacitances 12 are controlled by the sixth digit $S_6$ and are normally closed.

The sixth digit $S_6$ is a burst control signal corresponding to a signal B produced by the digital base band unit. In TDMA or similar modes where signal transmittance is by bursts $S_6$ is high during time-out, keeping switches 27a, 27a' open so that the charge is preserved in capacitances 12 and their proper function is assured from the beginning of the subsequent burst. Seventh digit $S_7$ controls switches 27b, 27b' whereby external capacitors 26b, 26b' can be added in parallel to capacitors 26a, 26a' to increase the time constant of reverse path unit 6. $S_7$ may be controllable directly by the user.

The analog base band unit described above operates as follows:

An input signal will usually contain blocking self-mixing signals which, however, are sufficiently suppressed by low pass filter unit 1. The resulting signal is fed to the feedback circuit made up of the variable gain amplifier unit 2 and the reverse path unit 6. The transfer function G(s) of variable gain amplifier unit 2 is essentially constant up to an upper cut-off frequency where it quickly falls off to zero. The transfer function F(s) of reverse path unit 6 is essentially

$$(1) \quad F(s) \ = \ 1/(s\tau)$$

where $\tau$ is the time constant and s the complex frequency. The transfer function H(s) of the subsystem is accordingly

$$(2) \quad H(s) \ = \ G(s)/[1+G(s)F(s)] \ = \ s\tau G(s)/[s\tau+G(s)]$$

Obviously, H(0)=0, i. e., any DC offset present at the output of low pass filter 1 is eliminated. In addition to amplifying the signal with a gain controlled, as will be explained later, by control unit 13, the feedback circuit comprising variable gain unit 2 and reverse path unit 6 acts as a filter suppressing in particular DC and low frequency components from blocking and local oscillator self-mixing products.

With, e. g., a decrease in the gain and without compensating measures the cut-off frequency would decrease also which might compromise the function of the circuit. This can, however, be compensated for by an appropriate adaptation of the time constant $\tau$ of the reverse path unit 6. To this end, the states of switches 24a-e, 24a'-e' and 27,a, b, 27a',b' are - in the way explained above - controlled by the reverse path control signal S produced by decoder 16 in such a way that the time constant $\tau$ changes roughly proportionally with the gain G(s), which itself changes essentially proportionally with the gain control signal, voltage $V_c$. As a consequence, H(s), the transfer function of the feedback circuit made up of variable gain amplifyer unit 2 and reverse path unit 6 is merely rescaled in proportion with the changes in the gain G(s), its shape remaining essentially constant.

Control voltage $V_c$ is produced in a way depending on the state of selectors 20a, 20b, which depend on the chosen mode of operation. For instance, if a GPS signal is being processed, first selector 20a connects control logic 22 to the input of integrator 14 whose output is transmitted to the input of quantizer 15 by second selector 20b. The burst control and speed-up features are not used. The digital signal at the output of A/D converter 3 is converted back into the analog domain, fed to integrator 14 and filtered. The relatively slowly varying output voltage $V_c$ is then, via the second selector 20b, applied to variable gain amplifier unit 2 as gain control signal. At the same time, it is fed to quantizer 15 and controls the time constant of reverse path unit 6 via decoder 16 and the switches in filter network 8 so as to stabilize the cut-off frequency of the feedback circuit consisting of variable gain amplifier 2 and reverse path unit 6 as explained above.

If an intermittent signal is being processed like in TDMA systems, the burst control feature is activated. With frequency hopping systems like bluetooth speed-up is active.

The variable properties of the reverse path unit 6 can additionally be exploited for a different purpose in that during processing of a GPS signal the bandwidth of the analog base band unit is adapted to the specific requirements of a signal acquisition phase and a tracking phase subsequent to acquisition of the signal, respectively.

During acquisition of the signal it is advantageous to keep pre-correlation bandwidth relatively small in order to effectively suppress noise outside the signal band and achieve a high carrier to noise ratio at the output of A/D converter 3. The carrier to noise ratio x as a function of the bandwidth b (Fig. 5) has a maximum at a relatively small optimum value $b_0$ of the bandwidth where the pass band essentially coincides with the signal band. If the carrier to noise ratio y is at a maximum the sensitivity of the GPS receiver is optimal and search time and the probability of false alarm are small. Due to the specific properties of the GPS signal the optimum bandwidth $b_0$ is about 900 kHz. At higher bandwidths like $b_1$ the carrier to noise ratio y is considerably reduced.

On the other hand, a small pre-correlation bandwidth of the system will lead to severe distortions of the correlation peak in particular where multi-path distortions are present (solid line in Fig. 6 where correlation c is shown as a function of time shift t). Consequently, it is advantageous to use a large pre-correlation bandwidth during the signal tracking phase subsequent to signal acquisition. A large pre-correlation bandwidth leads to a sharp peak in the correlation signal (dashed line in Fig. 6) and a correspondingly high level of the output discriminator value and allows for narrow correlation spacing. As a consequence, tracking error is low. For instance, with a pre-correlation bandwidth of 2 MHz 1-chip correlation spacing can be attained. 0.5-chip correlation spacing requires 4 MHz pre-correlation bandwidth. By further extension of the bandwidth correlation spacing and, as a consequence, tracking error can be reduced to very low values with limits determined mainly by constraints on power consumption. The pre-correlation bandwidth is determined by the bandwidth of the analog base band unit and can be adapted essentially by appropriately controlling reverse path unit 6.

In wireless communication systems, the specific capabilities of the analog base band unit according to the invention can be used to advantage in receivers for multiple wireless communication standards.

**List of reference symbols**

| | |
|---|---|
| 1 | low pass filter unit |
| 2 | variable gain amplifier unit |
| 3 | A/D converter |
| 4 | sampler |
| 5 | quantizer |
| 6 | reverse path unit |
| 7 | inverter network |
| 8 | filter network |
| 9 | operational amplifier |
| 10 | variable resistances |
| 11 | operational amplifier |
| 12 | variable capacitances |
| 13 | control unit |
| 14 | integrator |
| 15 | quantizer |
| 16 | decoder |
| 17 | transconductance |
| 18 | condenser |
| 19 | speed-up input |
| 20a,b | selectors |
| 21 | synchronous AM detector |
| 22 | logic circuit |
| 23a-d, 23a'-d' | resistors |
| 24a-e, 24a'-e' | switches |
| 25, 25' | resistors |
| 26a,b, 26a',b' | capacitors |

| 27a,b, 27a',b' | switches |
| 28a-e | resistors |
| 29a-d | comparators |

**Claims**

1. Analog base band unit for a RF receiver, with a feedback circuit comprising a variable gain amplifier unit (2) whose gain is set depending on a gain control signal ($V_c$) and a reverse path unit (6) connecting an output of the variable gain amplifier unit (2) with the input of the same, and with a control circuit (13) configured to generate the gain control signal ($V_c$) dependent on an output signal of the variable gain amplifier unit (2), **characterized in that** the control unit (13) is further configured to generate an output signal (S) for controlling at least one time constant of the reverse path unit (6) in such a way that it varies roughly proportionally with the gain for continuous adaptation of the filter characteristics of said analog base band unit to the gain of said variable gain amplifier unit (2).

2. Analog base band unit according to claim 1,
   **characterized in that** the variable gain amplifier unit (2) is a variable gain amplifier chain made up of Gilbert cells or of amplification cells comprising operational amplifiers and switching networks.

3. Analog base band unit according to claim 1 or 2,
   **characterized in that** the reverse path unit (6) comprises a filter network (8) defining the at least one time constant of the reverse path unit (6).

4. Analog base band unit according to claim 3,
   **characterized in that** the filter network (8) comprises at least one variable resistance (10) controllable by the control unit (13).

5. Analog base band unit according to claim 4,
   **characterized in that** the variable resistance (10) comprises several resistors (23a-23d, 23a'-23d'), at least part of them each in series with at least one switch (24a-e, 24a'-e') controllable by the control unit (13).

6. Analog base band unit according to one of claims 3 to 5, **characterized in that** the filter network (8) comprises at least one variable capacitance (12) controllable by the control unit (13).

7. Analog base band unit according to claim 6,
   **characterized in that** the at least one variable capacitance (12) comprises several capacitors (26a, 26b, 26a', 26b'), at least part of them in series each with at least one switch (27a, 27b, 27a', 27b') controllable by the control unit (13).

8. Analog base band unit according to claim 6 or 7,
   **characterized in that** the variable capacitance (12) is part of a local feedback loop comprising an operational amplifier (11).

9. Analog base band unit according to one of claims 1 to 8, **characterized in that** the control unit (13) comprises a quantizer (15) comparing an input signal voltage ($V_c$) with several reference voltages ($V_{r1}$-$V_{r4}$) and providing digital output signals ($A_1$-$A_4$), each reflecting the result of one of the voltage comparisons and a decoder (16) for processing the said digital signals to provide at least part of a reverse path control signal (S) for controlling the time constant of the reverse path unit (6).

10. Analog base band unit according to one of claims 1 to 9, **characterized in that** the control unit (13) comprises an integrator (14).

11. Analog base band unit according to claim 10,
    **characterized in that** the integrator (14) has a speed-up input (19) for receiving a speed-up signal.

12. Analog base band unit according to one of claims 1 to 11, **characterized in that** it comprises a selector (20a) for connecting one of several inputs of the control unit (13) to further components of the same.

**13.** Analog base band unit according to claim 12,
**characterized in that** it comprises a first monitoring unit connected between the output of the variable gain amplifier unit (2) and a first input of the selector (20a).

**14.** Analog base band unit according to claim 13,
**characterized in that** the first monitoring unit is a synchronous AM detector (21).

**15.** Analog base band unit according to one of claims 1 to 14, **characterized in that** it comprises an A/D converter (3) for converting the output signal of the variable gain amplifier unit (2) to a digital signal.

**16.** Analog base band unit according to one of claims 12 to 14 and claim 15, **characterized in that** it further comprises a second monitoring unit connected between the output of the A/D converter (3) and a second input of the selector (20a).

**17.** Analog base band unit according to claim 16,
**characterized in that** the second monitoring unit comprises a D/A converter or a logic control unit (22).

**18.** Analog base band unit according to one of claims 6 to 17, **characterized in that** it comprises at least one switch (27a, 27a') controllable by a burst control signal to shut off the at least one variable capacitance (12) in the reverse path unit (6).

**19.** Analog base band unit according to one of claims 1 to 18, **characterized in that** it comprises a low pass filter unit (1) preceding the variable gain amplifier unit (2).

**20.** Method for using an analog base band unit according to one of claims 1 to 19 to process a GPS signal,
**characterized in that** the analog base band unit is controlled so as to process the signal with an acquisition bandwidth during a signal acquisition phase and with a larger tracking bandwidth during a subsequent signal tracking phase.

**21.** Method according to claim 20, **characterized in that** the tracking bandwidth is at least twice the acquisition bandwidth.

**Patentansprüche**

**1.** Analoge Basisbandeinheit für einen HF-Empfänger, mit einer Rückkopplungsschaltung umfassend eine Verstärkereinheit (2) mit variabler Verstärkung, deren Verstärkungsfaktor in Abhängigkeit von einem Verstärkungsregelungssignal ($V_c$) eingestellt wird, und eine Rückwegeinheit (6), die einen Ausgang der Verstärkereinheit (2) mit variabler Verstärkung an den Eingang derselben anschliesst, und mit einer Steuerschaltung (13), die so konfiguriert ist, dass sie das Verstärkungsregelungssignal ($V_c$) in Abhängigkeit von einem Ausgangssignal der Verstärkereinheit (2) mit variabler Verstärkung erzeugt, **dadurch gekennzeichnet, dass** die Steuereinheit (13) des Weiteren konfiguriert ist, um ein Ausgangssignal (S) zur Steuerung zumindest einer Zeitkonstante der Rückwegeinheit (6) auf solche Art zu erzeugen, dass diese ungefähr proportional zu dem Verstärkungsfaktor zur ständigen Anpassung der Filtereigenschaften der analogen Basisbandeinheit an den Verstärkungsfaktor der Verstärkereinheit (2) mit variabler Verstärkung variiert.

**2.** Analoge Basisbandeinheit nach Anspruch 1, **dadurch gekennzeichnet, dass** die Verstärkereinheit (2) mit variabler Verstärkung eine Kette von Verstärkern mit variabler Verstärkung ist, die aus Gilbertzellen oder Operationsverstärker und Schaltnetze umfassenden Verstärkungszellen besteht.

**3.** Analoge Basisbandeinheit nach Anspruch 1 oder 2, **dadurch gekennzeichnet, dass** die Rückwegeinheit (6) ein Filter-Netzwerk (8) umfasst, das die zumindest eine Zeitkonstante der Rückwegeinheit (6) definiert.

**4.** Analoge Basisbandeinheit nach Anspruch 3, **dadurch gekennzeichnet, dass** das Filter-Netzwerk (8) zumindest einen durch die Steuereinheit (13) steuerbaren variablen Widerstand (10) umfasst.

**5.** Analoge Basisbandeinheit nach Anspruch 4, **dadurch gekennzeichnet, dass** der variable Widerstand (10) mehrere Widerstände (23a-23d, 23a'-23d') umfasst, wobei zumindest ein Teil von diesen jeweils mit zumindest einem durch die Steuereinheit (13) steuerbaren Schalter (24a-e, 24a'-e') in Reihe liegt.

6. Analoge Basisbandeinheit nach einem der Ansprüche 3 bis 5, **dadurch gekennzeichnet, dass** das Filter-Netzwerk (8) zumindest eine durch die Steuereinheit (13) steuerbare variable Kapazität (12) umfasst.

7. Analoge Basisbandeinheit nach Anspruch 6, **dadurch gekennzeichnet, dass** die zumindest eine variable Kapazität (12) mehrere Kondensatoren (26a, 26b, 26a', 26b') umfasst, wobei zumindest ein Teil von diesen jeweils mit zumindest einem durch die Steuereinheit (13) steuerbaren Schalter (27a, 27b, 27a', 27b') in Reihe liegt.

8. Analoge Basisbandeinheit nach Anspruch 6 oder 7, **dadurch gekennzeichnet, dass** die variable Kapazität (12) Teil einer lokalen Rückkopplungsschleife ist, die einen Operationsverstärker (11) umfasst.

9. Analoge Basisbandeinheit nach einem der Ansprüche 1 bis 8, **dadurch gekennzeichnet, dass** die Steuereinheit (13) eine Quantisiereinheit (15) umfasst, welche die Eingangssignalspannung ($V_c$) mit mehreren Referenzspannungen ($V_{r1}$-$V_{r4}$) vergleicht und digitale Ausgangssignale ($A_1$-$A_4$) liefert, die jeweils das Ergebnis eines der Spannungsvergleiche widerspiegeln, sowie einen Dekoder (16) zur Verarbeitung der digitalen Signale, um zumindest einen Teil des Rückweg-Steuersignals (S) zur Steuerung der Zeitkonstanten der Rückwegeinheit (6) zu liefern.

10. Analoge Basisbandeinheit nach einem der Ansprüche 1 bis 9, **dadurch gekennzeichnet, dass** die Steuereinheit (13) einen Integrierer (14) umfasst.

11. Analoge Basisbandeinheit nach Anspruch 10, **dadurch gekennzeichnet, dass** der Integrierer (14) einen Beschleunigungseingang (19) zum Empfang eines Beschleunigungssignals aufweist.

12. Analoge Basisbandeinheit nach einem der Ansprüche 1 bis 11, **dadurch gekennzeichnet, dass** sie einen Selektor (20a) für den Anschluss eines von mehreren Eingängen der Steuereinheit (13) an weitere Komponenten derselben umfasst.

13. Analoge Basisbandeinheit nach Anspruch 12, **dadurch gekennzeichnet, dass** sie eine erste Überwachungseinheit umfasst, die zwischen dem Ausgang der Verstärkereinheit (2) mit variabler Verstärkung und einem ersten Eingang des Selektors (20a) angeschlossen ist.

14. Analoge Basisbandeinheit nach Anspruch 13, **dadurch gekennzeichnet, dass** die erste Überwachungseinheit ein synchroner AM-Detektor (21) ist.

15. Analoge Basisbandeinheit nach einem der Ansprüche 1 bis 14, **dadurch gekennzeichnet, dass** sie einen A/D-Wandler (3) zur Umsetzung des Ausgangssignals der Verstärkereinheit (2) mit variabler Verstärkung in ein digitales Signal umfasst.

16. Analoge Basisbandeinheit nach einem der Ansprüche 12 bis 14 und Anspruch 15, **dadurch gekennzeichnet, dass** sie des Weiteren eine zweite Überwachungseinheit umfasst, die zwischen dem Ausgang des A/D-Wandlers (3) und einem zweiten Eingang des Selektors (20a) angeschlossen ist.

17. Analoge Basisbandeinheit nach Anspruch 16, **dadurch gekennzeichnet, dass** die zweite Überwachungseinheit einen D/A-Wandler oder eine Logiksteuereinheit (22) umfasst.

18. Analoge Basisbandeinheit nach einem der Ansprüche 6 bis 17, **dadurch gekennzeichnet, dass** sie zumindest einen durch ein Burst-Steuersignal steuerbaren Schalter (27a, 27a') umfasst, um die zumindest eine variable Kapazität (12) in der Rückwegeinheit (6) abzutrennen.

19. Analoge Basisbandeinheit nach einem der Ansprüche 1 bis 18, **dadurch gekennzeichnet, dass** sie eine Tiefpassfiltereinheit (1) umfasst, die der Verstärkereinheit mit variabler Verstärkung (2) vorausgeht.

20. Verfahren zur Nutzung einer analogen Basisbandeinheit nach einem der Ansprüche 1 bis 19 zur Verarbeitung eines GPS-Signals, **dadurch gekennzeichnet, dass** die analoge Basisbandeinheit so gesteuert wird, dass das Signal während einer Signalerfassungsphase mit einer Erfassungsbandbreite verarbeitet wird, und während einer darauf folgenden Signalnachführungsphase mit einer grösseren Nachführungsbandbreite.

**21.** Verfahren nach Anspruch 20, **dadurch gekennzeichnet, dass** die Nachführungsbandbreite zumindest das Zweifache der Erfassungsbandbreite beträgt.

**Revendications**

**1.** Unité de bande de base analogique pour un récepteur RF, avec un circuit de rétroaction comprenant une unité d'amplificateur de gain variable (2) dont le gain est réglé en fonction d'un signal de commande de gain ($V_c$) et une unité de chemin inverse (6) connectant une sortie de l'unité d'amplificateur de gain variable (2) à l'entrée de celle-ci, et avec un circuit de commande (13) configuré pour générer le signal de commande de gain ($V_c$) en fonction d'un signal de sortie de l'unité d'amplificateur de gain variable (2), **caractérisée en ce que** l'unité de commande (13) est en outre configurée pour générer un signal de sortie (S) pour commander au moins une constante de temps de l'unité de chemin inverse (6) de sorte qu'elle varie sensiblement proportionnellement avec le gain pour l'adaptation continue des caractéristiques de filtre de ladite unité de bande de base analogique au gain de ladite unité d'amplificateur de gain variable (2).

**2.** Unité de bande de base analogique selon la revendication 1, **caractérisée en ce que** l'unité d'amplificateur de gain variable (2) est une chaîne d'amplificateurs de gain variable constituée de cellules Gilbert ou de cellules d'amplification comprenant des amplificateurs opérationnels et des réseaux de commutation.

**3.** Unité de bande de base analogique selon la revendication 1 ou 2, **caractérisée en ce que** l'unité de chemin inverse (6) comprend un réseau de filtre (8) définissant l'au moins une constante de temps de l'unité de chemin inverse (6).

**4.** Unité de bande de base analogique selon la revendication 3, **caractérisée en ce que** le réseau de filtre (8) comprend au moins une résistance variable (10) pouvant être commandée par l'unité de commande (13).

**5.** Unité de bande de base analogique selon la revendication 4, **caractérisée en ce que** la résistance variable (10) comprend plusieurs résistances (23a-23d, 23a'-23d'), au moins une partie d'entre elles étant chacune en série avec au moins un commutateur (24a-e, 24a'-e') pouvant être commandé par l'unité de commande (13).

**6.** Unité de bande de base analogique selon l'une des revendications 3 à 5, **caractérisée en ce que** le réseau de filtre (8) comprend au moins une capacité variable (12) pouvant être commandée par l'unité de commande (13).

**7.** Unité de bande de base analogique selon la revendication 6, **caractérisée en ce que** l'au moins une capacité variable (12) comprend plusieurs condensateurs (26a, 26b, 26a', 26b'), au moins une partie d'entre eux étant chacun en série avec au moins un commutateur (27a, 27b, 27a', 27b') pouvant être commandé par l'unité de commande (13).

**8.** Unité de bande de base analogique selon la revendication 6 ou 7, **caractérisée en ce que** la capacité variable (12) fait partie d'une boucle de rétroaction locale comprenant un amplificateur opérationnel (11).

**9.** Unité de bande de base analogique selon l'une des revendications 1 à 8, **caractérisée en ce que** l'unité de commande (13) comprend un quantificateur (15) comparant une tension de signal d'entrée ($V_c$) à plusieurs tensions de référence ($V_{r1}$-$V_{r4}$) et fournissant des signaux de sortie numériques ($A_1$-$A_4$), reflétant chacun le résultat de l'une des comparaisons de tension, et un décodeur (16) pour traiter lesdits signaux numériques pour fournir au moins une partie d'un signal de commande de chemin inverse (S) pour commander la constante de temps de l'unité de chemin inverse (6).

**10.** Unité de bande de base analogique selon l'une des revendications 1 à 9, **caractérisée en ce que** l'unité de commande (13) comprend un intégrateur (14).

**11.** Unité de bande de base analogique selon la revendication 10, **caractérisée en ce que** l'intégrateur (14) a une entrée d'accélération (19) pour recevoir un signal d'accélération.

**12.** Unité de bande de base analogique selon l'une des revendications 1 à 11, **caractérisée en ce qu'**elle comprend un sélecteur (20a) pour connecter l'une de plusieurs entrées de l'unité de commande (13) à d'autres composants de celle-ci.

**13.** Unité de bande de base analogique selon la revendication 12, **caractérisée en ce qu'**elle comprend une première unité de surveillance connectée entre la sortie de l'unité d'amplificateur de gain variable (2) et une première entrée du sélecteur (20a).

**14.** Unité de bande de base analogique selon la revendication 13, **caractérisée en ce que** la première unité de surveillance est un détecteur AM synchrone (21).

**15.** Unité de bande de base analogique selon l'une des revendications 1 à 14, **caractérisée en ce qu'**elle comprend un convertisseur analogique/numérique (3) pour convertir le signal de sortie de l'unité d'amplificateur de gain variable (2) en un signal numérique.

**16.** Unité de bande de base analogique selon l'une des revendications 12 à 14 et la revendication 15, **caractérisée en ce qu'**elle comprend en outre une deuxième unité de surveillance connectée entre la sortie du convertisseur analogique/numérique (3) et une deuxième entrée du sélecteur (20a).

**17.** Unité de bande de base analogique selon la revendication 16, **caractérisée en ce que** la deuxième unité de surveillance comprend un convertisseur numérique/analogique ou une unité de commande logique (22).

**18.** Unité de bande de base analogique selon l'une des revendications 6 à 17, **caractérisée en ce qu'**elle comprend au moins un commutateur (27a, 27a') pouvant être commandé par un signal de commande en rafale pour déconnecter l'au moins une capacité variable (12) dans l'unité de chemin inverse (6).

**19.** Unité de bande de base analogique selon l'une des revendications 1 à 18, **caractérisée en ce qu'**elle comprend une unité de filtre passe-bas (1) précédant l'unité d'amplificateur de gain variable (2).

**20.** Procédé d'utilisation d'une unité de bande de base analogique selon l'une des revendications 1 à 19 pour traiter un signal GPS, **caractérisé en ce que** l'unité de bande de base analogique est commandée de manière à traiter le signal avec une largeur de bande d'acquisition au cours d'une phase d'acquisition de signal et avec une largeur de bande de suivi plus grande au cours d'une phase de suivi de signal ultérieure.

**21.** Procédé selon la revendication 20, **caractérisé en ce que** la largeur de bande de suivi est égale à au moins deux fois la largeur de bande d'acquisition.

Fig.1

Fig. 2

Fig. 3

Fig. 5

Fig. 6

Fig.4

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6031878 A